# EUROPEAN PATENT SPECIFICATION

(11) **EP 1 493 848 B1**
(45) Date of publication and mention of the grant of the patent: **08.12.2010**
(21) Application number: 03715636.1
(22) Date of filing: 31.03.2003
(51) Int. Cl.: C30B 29/36

(54) **SEED CRYSTAL OF SILICON CARBIDE SINGLE CRYSTAL AND METHOD FOR PRODUCING INGOT USING SAME**
IMPFKRISTALL AUS SILICIUMCARBID-EINKRISTALL UND VERFAHREN ZUR HERSTELLUNG EINES STABS DAMIT
CRISTAL GERME DE MONOCRISTAL DE CARBURE DE SILICIUM ET PROCEDE DE PRODUCTION DE LINGOT AU MOYEN DE CELUI-CI

(30) Priority: 04.04.2002 JP 2002102682; 04.04.2002 JP 2002102683; 27.05.2002 JP 2002152966
(43) Date of publication of application: 05.01.2005
(73) Proprietor: Nippon Steel Corporation, Tokyo 100-8071 (JP)
(72) Inventor: OHTANI, Noboru, c/o NIPPON STEEL CORPORATION, Futtsu-shi, Chiba 293-0011 (JP); KATSUNO, Masakazu, c/o NIPPON STEEL CORPORATION, Futtsu-shi, Chiba 293-0011 (JP); FUJIMOTO, Tatsuo, c/o NIPPON STEEL CORPORATION, Futtsu-shi, Chiba 293-0011 (JP)
(74) Representative: Vossius & Partner
(86) International application number: PCT/JP2003/004058
(87) International publication number: WO 2003/085175

(56) References cited:
- JP-A- 10 017 399
- JP-A- 11 106 297
- US-A- 5 958 132
- TAKAHASHI J ET AL: "INFLUENCE OF THE SEED FACE POLARITY ON THE SUBLIMATION GROWTH OF ALPHA-SIC" JAPANESE JOURNAL OF APPLIED PHYSICS, JAPAN SOCIETY OF APPLIED PHYSICS, TOKYO, JP, vol. 34, no. 9A, PART 1, September 1995 (1995-09), pages 4694-4698, XP000703025 ISSN: 0021-4922
- JUN TAKAHASHI ET AL: "SUBLIMATION GROWTH OF SIC SINGLE CRYSTALLINE INGOTS ON FACES PERPENDICULAR TO THE (0001) BASAL PLANE" JOURNAL OF CRYSTAL GROWTH, ELSEVIER, AMSTERDAM, NL, vol. 135, no. 1/2, January 1994 (1994-01), pages 61-70, XP000486364 ISSN: 0022-0248
- TAIROV Y M ET AL: "GENERAL PRINCIPLES OF GROWING LARGE-SIZE SINGLE CRYSTALS OF VARIOUS SILICON CARBIDE POLYTYPES" JOURNAL OF CRYSTAL GROWTH, ELSEVIER, AMSTERDAM, NL, vol. 52, 1981, pages 146-150, XP000647913 ISSN: 0022-0248
- TAKASHI ET AL: "Sublimation growth of 6H- and 4H- SiC single crystals in the [1-100] and [11-20] directions" J. CRYSTAL GROWTH, vol. 181, 1997, pages 229-240, NL

## Description

The present invention relates to a seed crystal consisting of a silicon carbide single crystal suitable for producing a substrate (wafer) for an electric power device, a high-frequency device or the like, and a method for producing an ingot using the same.

Silicon carbide (SiC) has attracted a great deal of attention as material for an environmental resistance semiconductor because of its physical and chemical properties such as excellent in heat resistance and mechanical strength, durability against radiation, and the like. Further, in recent years, demand for a silicon carbide single crystal wafer as a substrate wafer for a short wavelength optical device from blue to ultra violet light, a high-frequency high blocking voltage electron device, and the like has been increased. However, a crystal-growing technology capable to supply a large size and high-quality silicon carbide single crystal in an industrial scale and stably has not been established yet. Therefore, though silicon carbide is material for a semiconductor having many merits and possibilities as described above, practical application of this material has been hindered.

Hitherto, in a laboratory scale or so, a silicon carbide single crystal having a size possible to prepare a semiconductor device by growing a silicon carbide single crystal, for instance, by a sublimation recrystallization method (Lely method) has been obtained. However, with this method, the size of obtained single crystal is small and it is difficult to control the size and shape with a high degree of precision. Besides, it is not easy to control crystal polymorphism and impurity-carrier concentration of silicon carbide.

Further, it is also practiced to grow a cubic silicon carbide single crystal by performing heteroeptaxial growing on a different kind of substrate such as silicon using a chemical vapor deposition method (CVD method). Though a large size single crystal can be obtained with this method, only a silicon carbide single crystal containing many defects (up to 10⁷ defects/cm²) due to existence of as much as about 20% of lattice mismatch with a substrate, and so on, and it is not easy to obtain a high-quality silicon carbide single crystal. In order to solve these problems, a modified Lely method to perform sublimation recrystallization using a {0001} wafer consisting of a silicon carbide single crystal as a seed crystal has been proposed (Yu. M. Tairov and V. F. Tsvetkov, Journal of Crystal Growth, Vol. 52 (1981) pp. 146-150) .

US-A-5958132 teaches a method for the growth of a SiC single crystal using a seed crystal of SiC having an exposed face deviating from the {0001} plane by an angle between 60° and 120° in the direction of the {10-10} plane.

JP-A-10-017399 and JP-A-11-106297 both teach growing SiC on a (11-20) surface with a range of allowed inclinations for this surface. In both no inclination is preferred.

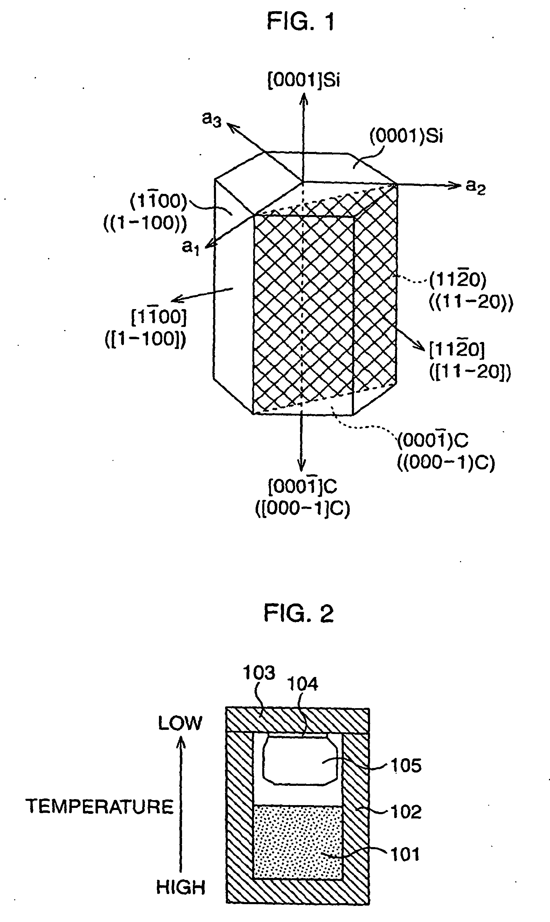

Incidentally, in the present application, a face index is described based on the Miller index notation method. FIG. 1 is a diagram showing face indices of a hexagonal silicon carbide single crystal.

By using the above-described method, the nucleation process of the crystal can be controlled because this method uses a seed crystal. Further, by controlling the ambient pressure from 100 Pa to about 15 kPa using inert gas, the growth rate of the crystal can be controlled with good reproducibility.

The principle of the modified Lely method will be explained using FIG. 2. A silicon carbide single crystal being a seed crystal and a silicon carbide crystal powder 101 being raw material are put into, for instance, a graphite crucible 102. And a seed crystal (silicon carbide wafer) 104 is fixed on the inner surface of a crucible lid 103. Then, the inside of the crucible 102 is heated to 2000 to 2400°C under inert gas atmosphere (133Pa to 13.3kPa) such as argon gas or the like. At this time, temperature gradient is set so that the seed crystal 104 is slightly lower in temperature compared with the silicon carbide crystal powder 101. When the silicon carbide crystal powder 101 is sublimated, concentration gradient of the raw material gas appears inside the crucible 102 by the temperature gradient so that raw material gas diffuses toward the seed crystal 104 side by the concentration gradient.

Single crystal growth is realized by recrystallization of the raw material gas arriving at the seed crystal 104 on the seed crystal 104 to form a growing crystal 105. At this time, it is possible to control resistivity of the growing crystal 105 by adding impurity gas in inert gas atmosphere or mixing impurity elements or their compounds in the silicon carbide crystal powder 101.

Typical substitutional type impurities in a silicon carbide single crystal are nitrogen (n-type), boron, and aluminum (p-type). When using the modified Lely method, it is possible to grow a silicon carbide single crystal while controlling crystal polymorphism (6H-type, 4H-type, 15R-type and so on), a shape, a carrier type and concentration of the silicon carbide single crystal.

Crystal polymorphism (polytype) of a silicon carbide single crystal produced by the modified Lely method are usually 6H-type and 4H-type, and these two polytype silicon carbide single crystal wafers are on the market at present. Especially, the 4H-type silicon carbide single crystal wafer has high electron mobility, and said to be suitable for power device usage. Note that a large size silicon carbide single crystal of 15R-type which is unstable polytype has not yet obtained at present.

Polytype of silicon carbide single crystal is almost determined by face polarity of a {0001} face crystal used for crystal growth. Regarding the {0001} face, there are two kinds of the (0001) Si face and the (000-1) C face which are different in polarity, and the outermost surfaces of respective faces are covered with a silicon atom layer and a carbon atom layer. A word {0001} is a generic term of these two faces.

It is possible for a 6H-type silicon carbide single crystal to grow when either of these polarized faces is used as a growing face, but for a 4H-type silicon carbide single crystal, it is possible to grow only when the (000-1) C face type crystal is used. Accordingly, in order to obtain a 4H-type silicon carbide single crystal suitable for power device usage, it is required to grow crystal on the (000-1) C face type crystal.

Currently, a {0001} face silicon carbide single crystal wafer having a diameter of 2 inches (50 mm) to 3 inches (75 mm) is cut from a silicon carbide single crystal prepared by the above-described modified Lely method and supplied to epitaxial thin film growth and device production.

When an electric power device, a high-frequency device, or the like is produced using a silicon carbide single crystal wafer, it is usually required for a silicon carbide thin film to undergo epitaxial growth on the wafer. Regarding this method, it is typical to deposit the silicon carbide thin film on a silicon carbide wafer using the so-called thermal CVD method (thermal chemical vapor deposition method). As a face direction of a silicon carbide wafer, the (0001) Si face or the (000-1) C face are usually selected.

However, in these silicon carbide single crystal wafers, about 50 to 200 /cm² of pinhole defects of several µm in diameter, passing through in the growth direction are contained. The pinhole defect is a threading dislocation called a micropipe and is succeeded as it is even during the epitaxial growth.

As described in a document "P. G. Neudeck et al., IEEE Electron Device Letters, Vol. 15 (1994) pp. 63 to 65", leak current or the like is caused by these defects. Further, a device produced on a micropipe is known that its characteristics are deteriorated (T. Kimoto et al., IEEE Tran. Electron. Device, vol. 46 (1999) PP, 471-477). Accordingly, reduction of the micropipe defects is one of the most important problems in device application of a silicon carbide single crystal.

To such a situation, in Japanese Patent Application Laid-open No. Hei 5-262599, it is disclosed that generation of micropipe defects can be completely prevented by growing a silicon carbide single crystal in a direction perpendicular to a <0001> direction taking a face perpendicular to a {0001} face as a growing face of the seed crystal. Further, when a silicon carbide single crystal is allowed to grow in a direction perpendicular to the <0001> direction, it is reported that the growing crystal completely succeeds a polytype structure of the seed crystal. For instance, in a document "J. Takahashi et al., J. Cryst. Growth, vol. 135 (1994) pp. 61 to 70", it is described that in a silicon carbide single crystal growing in the [1-100] direction or the [11-20] direction, there exists no micropipes. Further, in a document "H. Yano et al., Materials Science Forum, Vol. 338 to 342 (2000) pp. 1105 to 1108", it is described that in case of a 4H-silicon carbide, a MOS (Metal-Oxide-Semiconductor) type field effect transistor using the (11-20) face, which is a face perpendicular to the {0001} face, shows markedly higher channel mobility compared with that prepared on the (0001) Si face, namely, about 20 times of electron mobility as much as that prepared on the (0001) Si face.

As described above, the silicon carbide single crystal grown on a face perpendicular to the {0001} face does not contain micropipe defects, and a face perpendicular to the {0001} face is said to be a useful face for producing devices. Especially, the (11-20) wafer obtained by cutting and polishing a silicon carbide single crystal ingot grown in the [11-20] direction is suitable for preparing a high-performance silicon carbide device. Consequently, there has been a growing attention to an epitaxial thin film which has grown on a wafer having the (11-20) face.

However, when a silicon carbide single crystal has grown in this direction, as described in a document "J. Takahashi et al., Journal of Crystal Growth, Vol. 181 (1997) pp. 229 to 240", it is known that a plenty of stacking faults along the (0001) face are introduced into the crystal. As a result, even using a method disclosed in Japanese Patent Application No. Hei 5-262599, though generation of micropipe defects can be suppressed, a plenty of stacking faults causing unfavorable effect to devices are generated.

An object of the present invention is to provide a seed crystal which is capable to produce materials having less defects and a diameter suitable for practical application, and made of a silicon carbide single crystal, and a method for producing a silicon carbide single crystal ingot, a silicon carbide single crystal ingot, a silicon carbide single crystal wafer, a silicon carbide single crystal epitaxial substrate, a substrate for growing a silicon carbide single crystal epitaxial thin film (single crystal substrate), and a method of producing a silicon carbide single crystal epitaxial substrate.

A seed crystal consisting of a silicon carbide single crystal relating to a first invention of the present application includes a single crystal growing face inclined at an angle ranging from 3 degrees or more to 60 degrees or less with respect to the (11-20) face to a direction inclined at an angle ranging from -45 degrees or more to 45 degrees or less from a <0001> direction to the [1-100] direction.

A single crystal substrate consisting of a silicon carbide single crystal relating to a second invention of the present application includes an epitaxial growing face inclined at an angle ranging from 3 degrees or more to 60 degrees or less with respect to the (11-20) face to a direction inclined at an angle ranging from -45 degrees or more to 45 degrees or less from a <0001> direction to the [1-100] direction.

A method of producing a silicon carbide single crystal ingot relating to a third invention of the present application includes the steps of: obtaining a seed crystal consisting of a silicon carbide single crystal, and having a single crystal growing face inclined at an angle ranging from 3 degrees or more to 60 degrees or less with respect to the (11-20) face to a direction inclined at an angle ranging from -45 degrees or more to 45 degrees or less from a <0001> direction to the [1-100] direction; and allowing to grow a silicon carbide single crystal by a sublimation recrystallization method on the single crystal growing face of said seed crystal.

A silicon carbide single crystal ingot relating to a fourth invention of the present application is produced by the method described above, and the diameter of the ingot measures 20 mm or more.

A silicon carbide single crystal wafer relating to a fifth invention of the present application is produced by processing and polishing the silicon carbide single crystal ingot described above, and the diameter of said wafer measures 20 mm or more.

A silicon carbide single crystal epitaxial substrate relating to a sixth invention of the present application includes: the silicon carbide single crystal wafer described above; and a silicon carbide single crystal epitaxial film having grown on the silicon carbide single crystal wafer.

A method of producing a silicon carbide single crystal epitaxial substrate relating to a seventh invention of the present application includes the steps of: obtaining a substrate consisting of a silicon carbide single crystal, and having a single crystal growing face inclined at an angle ranging from 3 degrees or more to 60 degrees or less with respect to the (11-20) face to a direction inclined at an angle ranging from -45 degrees or more to 45 degrees or less from a <0001> direction to the [1-100] direction; and allowing to grow a silicon carbide single crystal epitaxial film on the single crystal growing face of the above-described substrate.

The silicon carbide single crystal epitaxial substrate relating to an eighth invention of the present application is produced by the above-described method and the diameter of the substrate measures 20 mm or more.
FIG. 1 is a view showing face indices of a hexagonal silicon carbide single crystal;
FIG. 2 is a diagram showing the principle of the modified Lely method;
FIG. 3 is a view showing the off-direction and the off-angle in the present invention;
FIG. 4A and FIG. 4B are views showing the principle of the present invention;
FIG. 5A and FIG. 5B are diagrams showing a relation between the off-direction of the seed crystal and a polytype of the growing crystal; and
FIG. 6 is a diagram showing an example of a production apparatus for the silicon carbide single crystal ingot.

Hereinafter, embodiments of the present invention will be explained referring to the attached drawings.

Growth of silicon carbide single crystals according to the modified Lely method is performed in such a manner that silicon carbide molecules sublimed from raw material adsorb on the surface of a seed crystal or a crystal which has grown on the seed crystal, and the grown molecule is captured regularly into the crystal.

Stacking faults which have been considered as a problem are induced by capturing silicon carbide molecules not in normal arrangement but in false arrangement when the silicon carbide molecules adsorbed on the crystal are captured into the crystal. The silicon carbide molecules captured in false arrangement bring a local strain in the crystal, which causes generation of stacking faults. The mechanism to generate such a stacking fault when the silicon carbide single crystal is allowed to grow in a direction perpendicular to the {0001} face is described in a document "Phys. Stat. Sol. (b) from page 163 to page 175 in Vol. 202 (1997) by J. Takahashi and N. Ohtani".

It should be noted that the stacking fault in question in the present invention is a defect induced by crystal growth which is generated only during crystal growing, and is different from a crystal defect generated by applying a mechanical or an electrical stress to a crystal grown after the crystal growth.

The present invention is achieved after the above-described mechanism has been analyzed, and as for Miller indices of silicon carbide single crystal, a face inclined by 3 degrees or more and 60 degrees or less with respect to the (11-20) face in a direction inclined by -45 degrees or more and 45 degrees or less from a <0001> direction to the [1-100] direction is taken as a single crystal growing face (single crystal raising face).

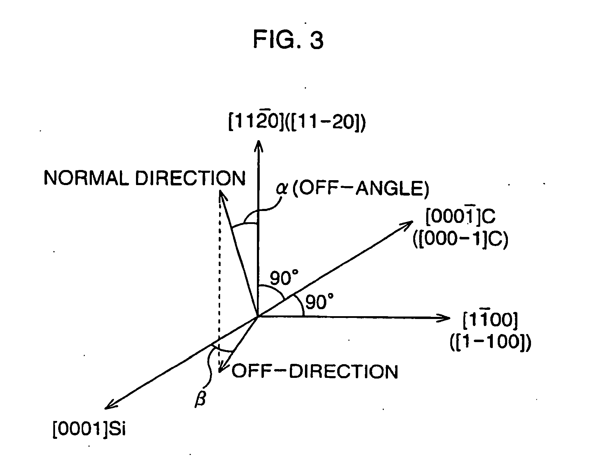

Note that the angle inclined with respect to a (11-20) face of the single crystal growing face is called "off-angle" and a direction introducing the off-angle is called "off-direction" in the following explanation. As shown in FIG. 3, the off-direction is in the plane including the directions <0001> and [1-100], and the normal line of the single crystal growing face is in the plane including the off-direction and the [11-20] direction.

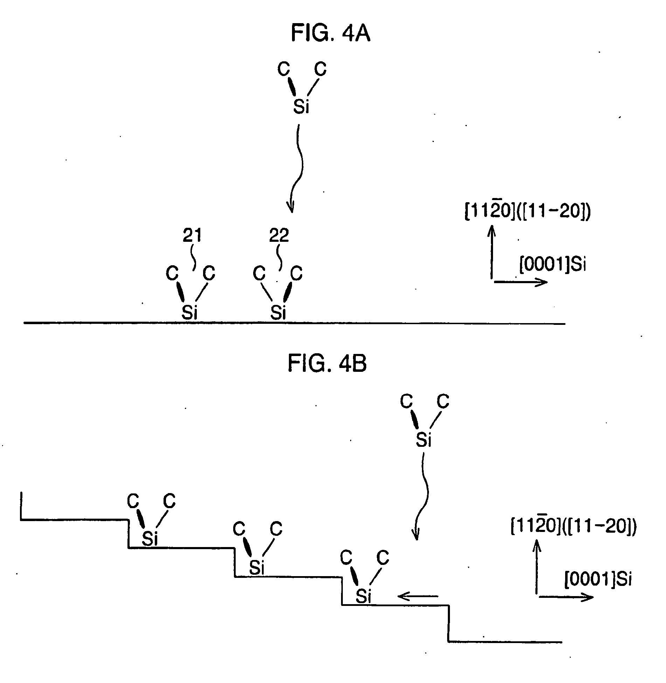

The principle of the present invention will be explained next using FIG. 4A and FIG. 4B.

Generally, among a plurality of arrangement forms a bond arrangement which is completely the same as that in the inside of the crystal is most stable in terms of energy. However, in a case of silicon carbide single crystal, since an energy difference between the arrangement forms is extremely small, the being adsorbed silicon carbide molecule is often captured in the crystal in a different arrangement from a regular arrangement (most stable arrangement).

For instance, when a crystal is allowed to grow on a seed crystal in which the (11-20) face itself is taken as a crystal growing face, that is, when a crystal is allowed to grow on a seed crystal in which the off-angle is not introduced to the (11-20) face, the silicon carbide molecule can take a plurality of arrangements on a crystal growing face as a bond arrangement. Namely, as shown in FIG. 4A, the silicon carbide molecule can take arrangement 21 (a bond arrangement which has completely the same bonding arrangement as that in the inside of the crystal, and is most stable in terms of energy) or arrangement 22 which is opposite in direction. When the silicon carbide molecule is captured in a false arrangement (arrangement 22), a stacking fault is generated in the silicon carbide single crystal from this point as a starting point.

On the other hand, when the off-angle is introduced to the (11-20) face, steps exist on the face of crystal growth as shown in FIG. 4B. At this time, gaps between the steps and the density of the steps depend on the magnitude of the off-angle. The smaller the off-angle, the larger the gaps become and the lower the density becomes, and conversely, the larger the off-angle, the smaller the gaps become and the higher the density becomes.

When the gaps between the steps of the crystal growing face are equal to or smaller than a certain value, all of the silicon carbide molecules coming from the raw material are held by the steps. When the silicon carbide molecules adsorb on the steps and are captured, the arrangement is determined non-ambiguously, and are not captured into crystal in a false arrangement. As a result, generation of a stacking fault is restrained.

Conventionally, technique for providing an off-angle on a crystal growing face has been adopted in a system using other materials. However, as for silicon carbide single crystal growth on the face (11-20), sufficient researches have not been performed. The present inventors have come up with conditions according to the present invention out of a number of conditions as a result of numerous experiments and considerations.

Next, the numerical restrictions and preferred embodiments in the present invention will be explained.

It is firstly required that the off-direction is in a direction inclined by -45 degrees or more and 45 degrees or less from a <0001> direction to the [1-100] direction, that is, it is required to be in the range of being shifted by ±45 degrees from a <0001> direction in the plane including the directions <0001> and [1-100]. In short, it is necessary that the angle β in FIG. 3 is -45 degrees or more and 45 degrees or less, or 135 degrees or more and 225 degrees or less.

When the angle β is 45 degrees or more and 135 degrees or less, or when it is -135 degrees or more and -45 degrees or less, the off-direction comes to be nearer to the [1-100] direction than the <0001> direction. Between this case and the case where the off-direction comes to be near to the <0001> direction, the structure of the steps and the like differ from each other. And when the off-direction comes near to the [1-100] direction, arbitrariness remains in an adsorption arrangement of silicon carbide molecules in the step so that a stacking fault can be generated. Therefore, the off-direction is required to be a direction inclined by -45 degrees or more and 45 degrees or less from a <0001> direction to the [1-100] direction.

Note that there are two directions of the [0001] Si direction and the [000-1] C direction in the <0001> direction, as described above. Either of the two directions may be used as the <0001> direction. When a 6H-type silicon carbide single crystal is allowed to grow, it is preferable to use the [0001] Si direction out of these two directions. Whereas when a 4H-type silicon carbide single crystal is allowed to grow, it is required to use the [000-1] C direction.

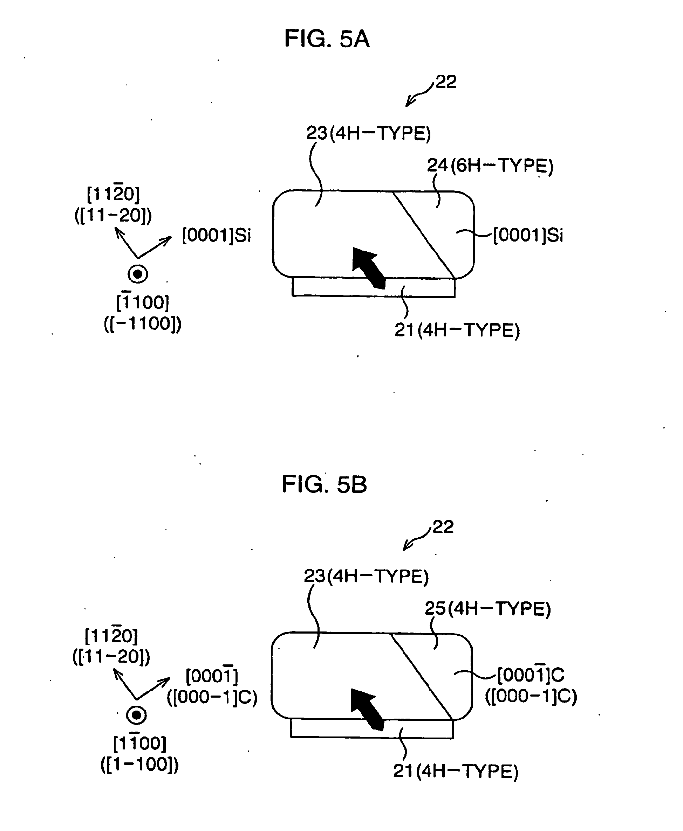

This is because when an off-direction is provided in the [0001] Si direction, though reduction of the stacking faults is achieved but it becomes difficult to obtain large size 4H-type silicon carbide single crystal. This principle will be explained using FIG. 5A and FIG. 5B.

As shown in FIG. 5A, when a seed crystal in which an off-angle is provided from the (11-20) face to the [0001] Si direction is used, a succeeding portion 23 having grown in a direction to succeed the polytype (4H-type) of the seed crystal 21 out of growing crystals 22 completely succeeds the polytype (4H-type) of the seed crystal, to exhibit a polytype of 4H-type. Incidentally, a growing direction of the succeeding portion 23 is a direction perpendicular to the <0001> direction, for instance, the [11-20] direction. On the contrary, as shown in FIG. 5A, polytype of a non-succeeding portion 24 in which no polytype to be succeeded exists, and a polytype is not determined through succeeding from a seed crystal, is determined based on a {0001} face which appears in a growing direction, in this case, based on the (0001) Si face. As described above, on the (0001) Si face, no polytype crystal of 4H-type grows. Accordingly, the polytype of the non-succeeding portion 24 comes to 6H-type or 6H-type with which polytype in 15R-type co-exists. Therefore, when an off-direction from the (11-20) face is in the [0001] Si direction, though stacking faults are reduced, large size silicon carbide single crystal of mono polytype of 4H-type cannot be obtained. On the contrary, when a seed crystal in which an off-angle is provided from the (11-20) face to the [000-1] C direction (FIG. 5B), a non-succeeding portion 25 grows on the (000-1) C face. Therefore, it is possible to obtain a 4H-type crystal even in the non-succeeding portion 25 if a growing condition is adequately selected. Accordingly, a large size silicon carbide single crystal of mono polytype of 4H-type can be obtained. Thus, as a result of assiduous studies such as performing a number of experiments and the like, the present inventors have found that even when a {0001} face is inclined against a growing direction, polytype in a portion of a growing crystal is determined according to the face direction.

Further, it is required that the off-angle is 3 degrees or more and 60 degrees or less with reference to the [11-20] direction, that is, the angle α in FIG. 3 is required to be 3 degrees or more and 60 degrees or less. When the off-angle is less than 3 degrees, since gaps between the steps on the surface of the seed crystal become too large and the density of the steps is lowered, the silicon carbide molecules are captured into the crystal even on a terrace existing between steps. At this time, since the terrace corresponds to a crystal growing face shown in FIG. 4A, the silicon carbide molecules can take a plurality of arrangements. Accordingly a stacking fault may be generated. On the other hand, when the off-angle exceeds 60 degrees, growth similar to conventional growth of the silicon carbide single crystal in the <0001> direction is performed. As a result, unfavorable micropipe defect is generated. Therefore, it is required for an off-angle to be 3 degrees or more and 60 degrees or less with reference to the [11-20] direction.

Incidentally, it is preferable for the off-angle to be an angle ranging from 3 degrees or more to 30 degrees or less, and more preferable from 6 degrees or more to 30 degrees or less.
A method for producing a seed crystal consisting of silicon carbide single crystal according to an embodiment of the present invention will be explained next.
Here, as an example, first, a wafer is cut from a 4H-type silicon carbide single crystal which has grown in the [000-1] C direction. At this time, a silicon carbide single crystal ingot to be used may contain micropipe defects but should not contain stacking faults. Regarding the cut face, a face inclined at an angle in the range from 3 degrees or more to 60 degrees or less with respect to the (11-20) face to an arbitrary direction inclined at an angle in the range from -45 degrees or more to 45 degrees or less from a <0001> direction of the silicon carbide single crystal to the [1-100] direction is taken as the cut face.
Then, by mirror-like polishing the cut wafer, a seed crystal according to an embodiment of the present invention can be produced. The seed crystal can be used for raising silicon carbide single crystal.
Incidentally, the deviation of the off-angle from the aforementioned arbitrary direction when cutting the wafer is preferably within ±1 degree.
Further, especially when a 4H-type seed crystal is produced, it is recommendable to take a face inclined at an angle ranging from 3 degrees or more to 60 degrees or less with respect to the (11-20) face to an arbitrary direction inclined at an angle ranging from -45 degrees or more to 45 degrees or less from the [000-1] C direction to the [-1100] direction of the silicon carbide single crystal as the cut face.

Then, it is possible to grow a silicon carbide single crystal, for instance, a 4H-type silicon carbide single crystal on a seed crystal by a sublimation recrystallization method using the seed crystal consisting of silicon carbide single crystal such as a 4H-type seed crystal produced thus. According to such a method, it is possible to obtain a silicon carbide single crystal such as a 4H-type silicon carbide single crystal of good quality which has few crystal defects such as micropipe defects, stacking faults and so on with good reproducibility.

Accordingly, it is possible to produce a silicon carbide single crystal ingot such as a 4H-type silicon carbide single crystal ingot having a diameter of 20 mm or more according to this production method. Such a silicon carbide single crystal ingot has a merit of having no micropipe defect exerting a bad effect on a device and extremely few stacking faults while having a large diameter of, for instance, 20 mm or more.

Here, a method of producing the silicon carbide single crystal ingot using a seed crystal according to the embodiments of the present invention will be explained concretely.

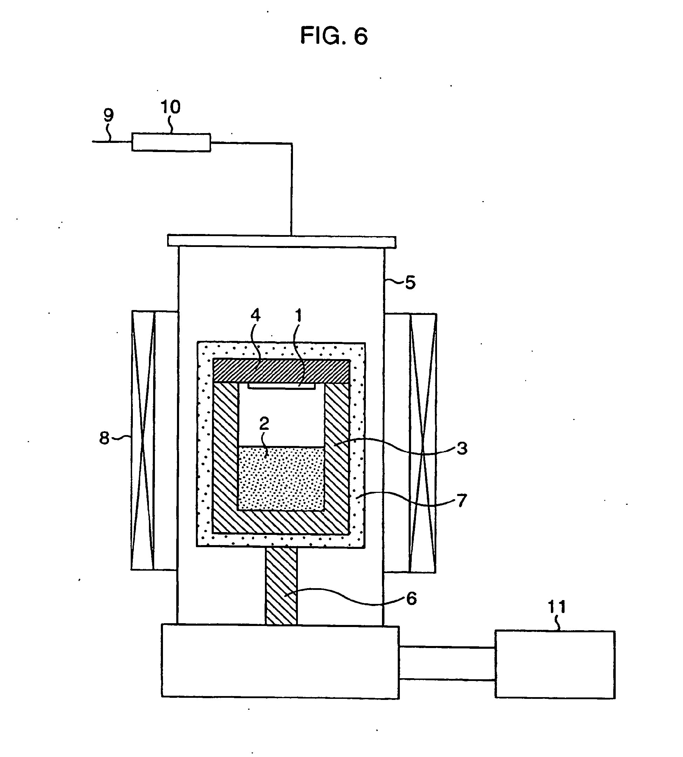

First, a producing apparatus of a silicon carbide single crystal ingot used in this method will be explained. FIG. 6 is a diagram showing an example of the producing apparatus of a silicon carbide single crystal ingot. In FIG. 6, an apparatus to make silicon carbide single crystal grow by the modified Lely method using a seed crystal.

The crystal growth is performed by sublimation-recrystallizing silicon carbide powder 2 which is a raw material on silicon carbide single crystal 1 used as a seed crystal. The silicon carbide single crystal 1 being a seed crystal is fixed on the inside face of a lid 4 of a crucible 3 made of graphite. The raw material silicon carbide powder 2 is filled in the inside of the graphite crucible 3.

The graphite crucible 3 is provided in the inside of a quartz-double tube 5 by a supporting bar 6 made of graphite. A felt 7 made of graphite for heat shielding is provided around the graphite crucible 3. The quartz-double tube 5 can be evacuated to a low pressure of 10⁻³Pa or less by a vacuum pump 11 and the inside atmosphere can be controlled in pressure by argon gas.

The pressure control by argon gas is performed through an argon gas plumbing 9 and a mass flow controller 10 for argon gas. Further, a work coil 8 is provided on the outer periphery of the quartz-double tube 5 which heats the graphite crucible 3 by flowing high-frequency electric current so as to heat the raw material and the seed crystal at a desired temperature. The measurement of the crucible temperature is performed by providing a light path of 2 to 4 mm in diameter at the center of the felt covering the upper portion and the lower portion of the crucible so as to let the light from the upper and lower portion of the crucible come out and by measuring with a two-color pyrometer. The temperature on the lower portion of the crucible 3 is taken as a raw material temperature and the temperature on the upper portion of the crucible 3 is taken as a seed temperature.

When producing silicon carbide single crystal, for instance, 4H-type silicon carbide single crystal using such a crystal growth system, the 4H-type silicon carbide seed crystal 1 relating to the present invention is fixed on the inside surface of the lid 4 of the graphite crucible 3 first. The raw material 2 is filled in the inside of the graphite crucible 3. Then, the graphite crucible 3 filled with the raw material is closed with the lid 4, on which the seed crystal is fixed, and the graphite crucible 3 is placed on the graphite supporting bar 6 after covering the graphite crucible 3 with the graphite felt 7, and set in the inside of the quartz-double tube 5.

Then, an electric current is fed through the work coil 8 after the inside of the quart tube is evacuated and the temperature of the raw material is raised to the predetermined temperature, for instance, up to about 1600°C. Thereafter, argon gas is passed through as an atmospheric gas, and the temperature of the raw material is raised to a target temperature, for instance, up to about 2400°C, while the pressure inside the quartz tube is kept at a predetermined pressure, for instance, at about 80kPa. Then, the pressure is slowly decreased to a predetermined growing pressure of, for instance, about 1.3kPa, and thereafter, by continuing growing of a single crystal for a predetermined period of time till the diameter becomes 20 mm or more, a 4H-type silicon carbide single crystal ingot can be obtained.

After obtaining a silicon carbide single crystal ingot such as a 4H-type silicon carbide single crystal ingot or the like, by giving conventional general cutting and polishing process, a silicon carbide single crystal substrate (wafer) having, for instance, a diameter of 20 mm or more can be obtained.

By using the wafer produced thus, a blue light-emitting device excellent in optical characteristics, and an electronic device excellent in electric characteristics can be produced.

The silicon carbide single crystal substrate (wafer) produced thus is provided with a characteristic of having an epitaxial growing face inclined at an angle in the range from 3 degrees or more to 60 degrees or less with respect to the (11-20) face to an inclined direction at an angle ranging from -45 degrees or more to 45 degrees or less from a <0001> direction (the [0001] Si direction or the [000-1] C direction) to the [1-100] direction, when the cut face is perpendicular to the growing direction.

Further, inevitably, when an off-angle of the used single crystal is from 3 degrees or more to 30 degrees or less, the inclined angle of the epitaxial growing face with respect to the (11-20) face becomes also from 3 degrees or more to 30 degrees or less, and when an off-angle of the used single crystal is from 6 degrees or more to 30 degrees or less, the inclined angle of the epitaxial growing face with respect to the (11-20) face becomes also from 6 degrees or more to 30 degrees or less.

However, the way to obtain such a silicon carbide single crystal substrate is not limited to that described above and may use the following method. That is, first, a substrate is cut from a 4H-type silicon carbide single crystal ingot which has grown in the [000-1] C direction. At this time, a silicon carbide single crystal ingot to be used may contain micropipe defects but no stacking fault. Regarding the cut face, a face inclined by 3 degrees or more and 60 degrees or less with respect to the (11-20) face to an arbitrary direction inclined at an angle ranging from -45 degrees or more to 45 degrees or less from a <0001> direction of the silicon carbide single crystal to the [1-100] direction is taken as the cut face.

Then, by performing mirror-like polishing on the cut substrate, a silicon carbide single crystal substrate (wafer) can be produced.

Incidentally, a deviation of the off-angle from the aforementioned arbitrary direction when cutting a wafer is preferably within ±1 degree.

It is possible to let a silicon carbide single crystal epitaxial film grow on a silicon carbide single crystal substrate by a thermal CVD method using silicon carbide single crystal substrate (wafer) produced thus. According to such a method, it is possible to obtain a silicon carbide single crystal epitaxial film of good quality which has few crystal defects such as a micropipe defect, a stacking fault and so on with good reproducibility.

Accordingly, it is possible to produce a silicon carbide single crystal epitaxial substrate having a diameter of 20 mm or more according to this production method. Such a silicon carbide single crystal epitaxial substrate has a merit of no micropipe defect, which exerts a bad effect on a device, and extremely few stacking faults while having a large diameter of, for instance, 20 mm or more.

Here, an example of methods of producing the silicon carbide single crystal epitaxial substrate using a silicon carbide single crystal substrate (wafer) according to an embodiment of the present invention will be explained concretely.

First, a silicon carbide single crystal substrate (wafer) according to an embodiment of the present invention is put on a susceptor made of graphite, and after putting it inside the crystal growing furnace of the thermal CVD apparatus, the inside of the crystal growing furnace is evacuated. Then, the evacuation is stopped, and after the pressure in the crystal growing furnace is returned to atmospheric pressure by introducing hydrogen gas, the susceptor is heated by induction heating while hydrogen gas is kept flowing. When the temperature of the susceptor reaches a predetermined temperature, for instance, about 1580°C, hydrogen chloride gas is allowed to flow in together with the hydrogen gas. The flow rates of the hydrogen gas and hydrogen chloride gas are preferably, for instance, 1.0 to 10.0×10⁻⁵ m³/sec, 0.3 to 3.0×10⁻⁷ m³/sec, respectively.

Thereafter, the hydrogen chloride gas is stopped, the temperature is decreased to a predetermined temperature, for instance, about 800°C while the hydrogen gas is kept flowing so that the hydrogen chloride gas inside the crystal growing furnace is purged. Then, the temperature is increased to a predetermined temperature, for instance, about 1500°C to start epitaxial growth.

As for the condition for growing the silicon carbide epitaxial thin film, it is preferable not to be limited to a certain condition and a suitable condition is preferably selected case by case. For instance, the growth temperature is set to be 1500°C, the flow rates of silane (SiH₄), propane (C₃H₈) and hydrogen (H₂) are set to be 0.1 to 10.0×10⁻⁹m³/sec, 0.6 to 6.0 × 10⁻⁹m³/sec, 1.0 to 10.0 × 10⁻⁵m³/sec. These conditions are preferably applied to the present invention. The growth pressure is preferably selected suitably according to other conditions for growing, and usually atmospheric pressure is used. The time for growth is not limited especially and sufficient so far as a desired film thickness after growth is obtained. For instance, the film thickness of 1 to 20µm can be obtained with 1 to 20 hours of the time of growth. The silicon carbide single crystal epitaxial substrate produced thus is extremely smooth over the entire wafer surface and has a favorable surface morphology with few surface defects caused by a micropipe defect and a stacking fault.

Next, embodiments of a silicon carbide seed crystal, silicon carbide single crystal substrate and the like produced by the present inventors and comparative examples will be explained.

### -First Embodiment -

Silicon carbide single crystal was produced using a crystal growth system shown in FIG. 6. Specifically, a wafer was cut from a 6H-type silicon carbide single crystal which had grown in the [000-1] C direction. At this time, a silicon carbide single crystal which included micropipe defects but no stacking fault was used. Regarding the cut face, a face inclined at an angle of 10 degrees to the [0001] Si direction with respect to the (11-20) face of the silicon carbide single crystal was taken as the cut face (α = 10°, β = 0°). Incidentally, the deviation of the off-direction from the [0001] Si direction was set to be within ± 1°.

And, a silicon carbide seed crystal 1 was obtained by mirror-like polishing the cut wafer. The diameter measured at this time was 20 mm at the smallest.

Thereafter, the seed crystal 1 was fixed on the inside surface of a lid 4 of a graphite crucible 3. A raw material 2 was placed in the graphite crucible 3. Then, the graphite crucible 3 filled with the raw material was covered with the lid 4, on which the seed crystal was fixed, and after covered with a graphite felt 7, it was put on the graphite supporting bar 6 to be placed inside the quartz-double tube 5.

Then, after the quartz tube was evacuated, an electric current was allowed to flow through the work coil 8 to heat the raw material to 1600°C. Thereafter, argon gas was allowed to flow in as an atmospheric gas, and the raw material temperature was increased to 2400°C which was the target temperature, while the pressure inside the quartz tube was kept to about 80 kPa. Subsequently, the pressure was reduced to 1.3 kPa being a pressure for growing, in about 30 minutes. Thereafter, it was kept growing for about 20 hours. The temperature gradient in the crucible at this time was set to 15°C/cm, and the growth rate was set to about 0.8 mm/hour. The diameter of the crystal obtained thus was 22 mm, and the height was about 16 mm.

By analyzing the silicon carbide single crystal thus obtained with X-ray diffractometry and Raman scattering, it was confirmed that a 6H-type silicon carbide single crystal was growing.

Further, in order to evaluate micropipe defects and stacking faults, wafers of the (0001) face and the (1-100) face were cut and polished. When performing this cutting, the single crystal ingot was cut in parallel or substantially parallel to the direction of growth. Then, the surfaces of the wafers were etched with molten KOH at about 530°C. Subsequently, the number of large hexagonal etch pits, which correspond to micropipe defects, in the wafer of the (0001) face, and the number of linear etch pits, which correspond to stacking faults, in the wafer of the (1-100) face were examined by microscopic observation. As a result, it was found that there was no micropipe defect at all and the stacking fault density was 4 /cm on average.

Next, a wafer of the (11-20) face was cut from a 6H-type silicon carbide single crystal ingot produced similarly. When performing this cutting, the single crystal ingot was cut substantially perpendicular to the direction of growth. The diameter was 22 mm. Then, the wafer was polished to 300µm in thickness to prepare a silicon carbide single crystal mirror finish wafer, the surface of which was the (11-20) face.

Further, as the silicon carbide single crystal mirror finish wafer was used as a substrate, epitaxial growth of silicon carbide on the substrate was performed. Regarding the growth conditions of the silicon carbide epitaxial thin film, the growth temperature was set to 1500°C, and the flow rates of silane (SiH₄), propane (C₃H₈) and hydrogen (H₂) were set to be 5.0×10⁻⁹m³/sec, 3.3×10⁻⁹m³/sec, 5.0×10⁻⁵m³/sec, respectively. As the pressure of growth, atmospheric pressure was used. After 4 hours, the film thickness of the grown epitaxial thin film was about 5µm.

After the epitaxial thin film was allowed to grow, the surface morphology of the silicon carbide epitaxial thin film obtained thus was observed with Nomarski optical microscope. As a result, it was found that the wafer was very flat over its entire surface, and was good because it had very few surface defects caused by micropipe defects and stacking faults.

Further, this epitaxial wafer (epitaxial substrate) was cleaved at the (1-100) face, and the cleaved face was etched with molten KOH to examine the stacking fault density in the epitaxial thin film. As a result, the stacking fault density was 4 /cm on average, similarly to the substrate at the time of forming the epitaxial thin film.

### -Second Embodiment-

Using a crystal growth system shown in FIG. 6, a silicon carbide single crystal was produced. Specifically, first, a wafer was cut from a 4H-type silicon carbide single crystal which had grown in the [000-1] C direction. At this time, a silicon carbide single crystal which included micropipe but no stacking faults was used. Regarding the cut face, a face inclined at an angle of 10 degrees with respect to the (11-20) face of the silicon carbide single crystal to the [000-1] C direction was taken as the cut face (a = 10°, ß = 180°). Incidentally, the deviation of the off-direction from the [000-1] C direction was set to be within ± 1°.

Then, a silicon carbide seed crystal was obtained by mirror-like polishing the cut wafer. The diameter measured at this time was 20 mm at the smallest.

Thereafter, the crystal was allowed to grow similarly to the first embodiment. As a result, the diameter of the obtained crystal was 22 mm and the height was about 16 mm.

By analyzing the silicon carbide single crystal obtained thus with X-ray diffractometry and Raman scattering, it was confirmed that a single polytype silicon carbide single crystal of 4H-type was growing.

Further, similarly to the first embodiment, evaluation of micropipe defects and stacking faults was performed. As a result, it was found that there were no micropipe defects at all and the stacking fault density was 4 /cm on average.

Next, the wafer of the (11-20) face was cut from a single polytype silicon carbide single crystal ingot of 4H-type which was produced in a manner similar to that described above. When performing this cutting, the single crystal ingot was cut substantially perpendicular to the direction of growth. The diameter was 22 mm. Then, the wafer was polished to 300µm in thickness to prepare a silicon carbide single crystal mirror finish wafer of which surface is the (11-20) face.

Further, as the silicon carbide single crystal mirror finish wafer was used as a substrate, silicon carbide epitaxial growth on the substrate was performed under the conditions similarly to the first embodiment. Similarly to the first embodiment, the grown epitaxial thin film was about 5 µm in thickness. Then, after the epitaxial thin film was allowed to grow, the surface morphology of the silicon carbide epitaxial thin film obtained thus was observed with Nomarski optical microscope. As a result, it was found that the wafer was very flat over the entire surface thereof, and was favorable because it had very few surface defects caused by micropipe defects and stacking faults.

Further, this epitaxial wafer (epitaxial substrate) was cleaved at the (1-100) face, and the cleaved face was etched with molten KOH to examine the stacking fault density in the epitaxial thin film. As a result, the stacking fault density was 4 /cm on average, similarly to the substrate at the time of forming the epitaxial thin film.

### -Third Embodiment-

Using the crystal growth system shown in FIG. 6, a silicon carbide single crystal was produced. Specifically, first, a wafer was cut from a 4H-type silicon carbide single crystal which had grown in the [000-1] C direction. At this time, the silicon carbide single crystal in which micropipe defects were contained but no stacking faults existed was used. Regarding the cut face, a face inclined at an angle of 10 degrees with respect to the (11-20) face of the silicon carbide single crystal in the [0001] Si direction was taken as the cut face (α = 10°, β = 0°). Incidentally, the deviation of the off-direction from the [0001] Si direction was set to be within ± 1°.

Then, a silicon carbide seed crystal was obtained by mirror-like polishing the cut wafer. The diameter measured at this time was 20 mm at the smallest.

Thereafter, the crystal was allowed to grow similarly to the first embodiment. However, the growth rate was set to 0.75 mm/sec. As a result, the diameter of the obtained crystal was 22 mm and the height was about 15 mm.

By analyzing the silicon carbide single crystal obtained thus with X-ray diffractometry and Raman scattering, it was confirmed that a 4H-type silicon carbide single crystal was growing at a portion where the silicon carbide single crystal had grown in succeeding the polytype of the seed crystal, and a 6H-type silicon carbide single crystal was growing at a portion where the silicon carbide single crystal had grown without succeeding the polytype of the seed crystal. In short, two polytypes mixedly existed.

Further, similarly to the first embodiment, evaluation of the micropipe defect and the stacking fault was performed. The result showed that no micropipe defects existed at all, and the stacking faults scarcely existed except in the vicinity of the boundary between the 4H-type polytype and the 6H-type polytype (stacking fault density: 10 /cm). However, in the vicinity of the boundary between portions of 4H-type and 6H-type, a number of stacking faults of 200 /cm were observed.

Next, the wafer of the (11-20) face was cut from a 4H-type silicon carbide single crystal ingot which was produced similarly. The diameter was set to 22 mm. Then, the wafer was polished to 300µm in thickness to prepare a silicon carbide single crystal mirror finish wafer having a surface of the (11-20) face.

Further, as the silicon carbide single crystal mirror finish wafer was used as a substrate, epitaxial growth of silicon carbide on the substrate was performed under the conditions similarly to the first embodiment. Similarly to the first embodiment, the thickness of the grown epitaxial thin film was about 5 µm.

Then, after the epitaxial thin film was allowed to grow, the polytype was analyzed by Raman scattering. The result showed that out of the silicon carbide single crystal mirror finish wafer, a 4H-type epitaxial thin film was formed on the 4H-type portion, and a 6H-type epitaxial thin film was formed on the 6H-type portion.

Further, using Nomarski optical microscope, the surface morphology of the silicon carbide epitaxial thin film obtained thus was observed, and it was found that surface defects caused by micropipe defects could not be observed at all, and surface defects caused by stacking faults was very few except in the vicinity of the boundary between the 4H-type and the 6H-type. However, there were a number of surface defects caused by stacking faults in the vicinity of the boundary between the 4H-type polytype and the 6H-type polytype.

Further, this epitaxial wafer (epitaxial substrate) was cleaved at the (1-100) face, and the cleaved face was etched with molten KOH to examine the stacking fault density in the epitaxial thin film. The result showed an extremely low stacking fault density of 10 /cm or less on average except in the vicinity of the boundary between the 4H-type polytype and the 6H-type polytype. However, in the vicinity of the boundary between the 4H-type portion and the 6H-type portion, the stacking fault density was very high of 200 /cm.

Thus, in the third embodiment, though the stacking faults existed in the vicinity of the boundary between the polytypes, reduction of the total amount of defects could be achieved.

### -First Comparative Example-

Using the crystal growth system shown in FIG. 6, a silicon carbide single crystal having the off-angle of 0 (zero) degrees was produced. Specifically, first, a wafer was cut from a 4H-type silicon carbide single crystal which had grown in the [000-1] C direction. At this time, a silicon carbide single crystal in which micropipe defects were contained but no stacking faults existed was used. Regarding the cut face, the (11-20) face of silicon carbide single crystal was taken as the cut face (α = 0°, β = 0°). Incidentally, the deviation of this surface from the (11-20) face was set to be within ± 0.5°.

Then, a silicon carbide seed crystal was obtained by mirror-like polishing the cut wafer. The diameter measured at this time was 20 mm at the smallest.

Thereafter, the crystal was allowed to grow similarly to the first embodiment. As a result, the diameter of the obtained crystal was 22 mm and the height was about 16 mm.

By analyzing the silicon carbide single crystal obtained thus by X-ray diffractometry and Raman scattering, it was confirmed that a 4H-type silicon carbide single crystal was growing.

Further, similarly to the first embodiment, evaluation of the micropipe defect and the stacking fault was performed. The result showed that though no micropipe defects existed at all, the stack defect density was extremely high of 170 /cm on average similarly to those prepared by conventional art.

Next, the wafer of the (11-20) face was cut from a 4H-type silicon carbide single crystal ingot which was produced in the same manner. The diameter was set to 22 mm. Then, the wafer was polished to 300µm in thickness to prepare a silicon carbide single crystal mirror finish wafer having a surface of the (11-20) face.

Further, the silicon carbide single crystal mirror finish wafer was used as a substrate, and epitaxial growth of silicon carbide on the substrate was performed under the conditions similarly to the first embodiment. Similarly to the first embodiment, the thickness of the grown epitaxial thin film was about 5 µm. Then, after the epitaxial thin film was allowed to grow, the surface morphology of the silicon carbide epitaxial thin film obtained thus was observed with Nomarski optical microscope. As a result, surface defects considered to be caused by stacking faults existed on the surface of the wafer.

Further, this epitaxial wafer (epitaxial substrate) was cleaved at the (1-100) face, and the cleaved face was etched with molten KOH to examine the stacking fault density in the epitaxial thin film. The result showed extremely high stacking fault density of 170 /cm on average, similarly to the substrate at the time of forming an epitaxial thin film.

### -Fourth Embodiment-

First, a wafer was cut from a 4H-type silicon carbide single crystal which had grown in the [000-1] C direction. At this time, a silicon carbide single crystal in which micropipe defects were contained but no stacking faults existed was used. Regarding the cut face, a face inclined at an angle of 10° with respect to the (11-20) face of the silicon carbide single crystal in the [0001] Si direction was taken as the cut face (α = 10°, β = 0°). Incidentally, the deviation of the off-direction from the [0001] Si direction was within ± 1°.

Then, an epitaxial growing substrate was obtained by mirror-like polishing the cut wafer. The diameter measured at this time was 20 mm at the smallest.

The epitaxial growing substrate was put on a graphite susceptor, and after putting it inside a crystal growing furnace of the thermal CVD apparatus, the inside of the crystal growing furnace was evacuated. Then, the evacuation was stopped, and after the pressure in the crystal growing furnace was returned to atmospheric pressure by introducing hydrogen gas, the susceptor was heated by induction heating while the hydrogen gas was kept flowing. When the temperature of the susceptor reached 1580°C, hydrogen chloride gas was allowed to flow in together with the hydrogen gas. The flow rates of the hydrogen gas and hydrogen chloride gas were 5.0×10⁻⁵ m³/sec and 1.7×10⁻⁷ m³/sec, respectively.

Thereafter, the hydrogen chloride gas was stopped, the temperature was decreased to 800°C while hydrogen gas was kept flowing so that the hydrogen chloride gas inside the crystal growing furnace was purged. Then, the temperature was raised to 1500°C to start epitaxial growth.

As for the condition for growing the silicon carbide epitaxial thin film, the growth temperature was set to be 1500°C, and the flow rates of silane (SiH₄), propane (C₃H₈) and hydrogen (H₂) were set to be 5.0×10⁻⁹/sec, 3.3×10⁻⁹m³/sec, 5.0×10⁻⁵m³/sec. As the growth pressure, atmospheric pressure was used. When the time of growth was taken for 4 hours, the film thickness of the grown epitaxial thin film was about 5 µm.

After the epitaxial thin film was allowed to grow, the surface morphology of the silicon carbide epitaxial thin film obtained thus was observed with Nomarski optical microscope. As a result, it was found that the wafer was very flat over the entire surface thereof, and was favorable because it had very few surface defects caused by micropipe defects and stacking faults.

Further, this epitaxial wafer (epitaxial substrate) was cleaved at the (1-100) face, and the cleaved face was etched with molten KOH to examine the stacking fault density in the epitaxial thin film. As a result, no etch pit corresponding to stacking faults was observed at all.

### -Second Comparative Example -

First, a wafer was cut from the 4H-type silicon carbide single crystal which had grown in the [000-1] C direction. At this time, a silicon carbide single crystal in which micropipe defects were contained but no stacking faults existed was used. Regarding the cut face, the (11-20) face of the silicon carbide single crystal was taken as the cut face (α = 0°, β = 0°). Incidentally, the deviation of this surface from the [11-20] direction was set to be within ± 0.5°.

Then, an epitaxial growing substrate was obtained by mirror-like polishing the cut wafer. The diameter measured at this time was 20 mm at the smallest.

Next, as similarly to the third embodiment, epitaxial growth was performed. As a result, the thickness of the epitaxial thin film obtained thus was about 5 µm.

After the epitaxial thin film was allowed to grow, the surface morphology of the silicon carbide epitaxial thin film obtained thus was observed with Nomarski optical microscope. As a result, it was found that surface defects considered to be caused by stacking faults existed on the surface of the wafer.

Further, this epitaxial wafer (epitaxial substrate) was cleaved at the (1-100) face, and the cleaved face was etched with molten KOH to examine the stacking fault density in the epitaxial thin film. As a result, it was found that the stacking fault density was 10 /cm in the epitaxial thin film.

As described above in detail, according to the present invention, it is possible to obtain material consisting of a silicon carbide single crystal of favorable quality, which has few crystal defects such as micropipe defects and stacking faults, and the diameter is suitable for practical application. By using a wafer made of such a silicon carbide single crystal, it is possible to produce a blue light-emitting device excellent in optical characteristics, an electronic device excellent in electric characteristics and the like. Further, by using especially a 4H-type silicon carbide single crystal wafer, an electric power device with an exceptionally low power loss compared with a conventional device can be produced.

## Claims

1. A seed crystal consisting of a silicon - carbide single crystal, comprising:
a single crystal growing face inclined at an angle ranging from 3 degrees or more to 60 degrees or less with respect to the (11-20) face to a direction inclined at an angle ranging from -45 degrees or more to 45 degrees or less from a <0001> direction to the [1-100] direction.

2. The seed crystal according to claim 1, wherein said <0001> direction is the [0001] Si direction.

3. The seed crystal according to claim 1, wherein said <0001> direction is the [000-1] C direction.

4. The seed crystal according to any one of claims 1 to 3, wherein said single crystal growing face is inclined at an angle ranging from 3 degrees or more to 30 degrees or less with respect to said (11-20) face.

5. The seed crystal according to any one of claims 1 to 3, wherein said single crystal growing face is inclined at an angle ranging from 6 degrees or more to 30 degrees or less with respect to said (11-20) face.

6. A single crystal substrate consisting of a silicon carbide single crystal, comprising:
an epitaxial growing face inclined at an angle ranging from 3 degrees or more to 60 degrees or less with respect to the (11-20) face to a direction inclined at an angle ranging from -45 degrees or more to 45 degrees or less from a <0001> direction to the [1-100] direction.

7. The single crystal substrate according to claim 6, wherein said <0001> direction is the [0001] Si direction.

8. The single crystal substrate according to claim 6, wherein said <0001> direction is the [000-1] C direction.

9. The single crystal substrate according to any one of claims 6 to 8 , wherein said epitaxial growing face is inclined at an angle ranging from 3 degrees or more to 30 degrees or less with respect to said (11-20) face.

10. The single crystal substrate according to any one of claims 6 to 8 , wherein said epitaxial growing face is inclined at an angle ranging from 6 degrees or more to 30 degrees or less with respect to said (11-20) face.

11. A method of producing a silicon carbide single crystal ingot, comprising the steps of:
obtaining a seed crystal consisting of a silicon carbide single crystal and having a single crystal growing face inclined at an angle ranging from 3 degrees or more to 60 degrees or less with respect to the (11-20) face to a direction inclined at an angle ranging from -45 degrees or more to 45 degrees or less from a <0001> direction to the [1-100] direction; and
allowing to grow a silicon carbide single crystal by a sublimation recrystallization method on said single crystal growing face of said seed crystal.

12. The method of producing a silicon carbide single crystal ingot according to claim 11, wherein the [0001] Si direction is selected as said <0001> direction in the step of obtaining said seed crystal.

13. The method of producing the silicon carbide single crystal ingot according to claim 11, wherein the [000-1] C direction is selected as said <0001> direction in the step of obtaining said seed crystal.

14. A silicon carbide single crystal ingot being produced by a method according to any one of claims 11 to 13, and a diameter thereof is 20 mm or more.

15. A silicon carbide single crystal wafer,
being produced by processing and polishing the silicon carbide single crystal ingot according to claim 14, and a diameter thereof is 20 mm or more.

16. A silicon carbide single crystal epitaxial substrate, comprising:
the silicon carbide single crystal wafer according to claim 15; and
a silicon carbide single crystal epitaxial film having grown on said silicon carbide single crystal wafer.

17. A method of producing a silicon carbide single crystal epitaxial substrate, comprising the steps of:
obtaining a substrate consisting of a silicon carbide single crystal and having a single crystal growing face inclined at an angle ranging from 3 degrees or more to 60 degrees or less with respect to the (11-20) face to a direction inclined at an angle ranging from -45 degrees or more to 45 degrees or less from a <0001> direction to the [1-100] direction; and
allowing to grow a silicon carbide single crystal epitaxial film on said single crystal growing face of said substrate.

18. The method of producing the silicon carbide single crystal epitaxial substrate according to claim 17, wherein the [0001] Si direction is selected as said <0001> direction in the step of obtaining said substrate.

19. The method of producing the silicon carbide single crystal epitaxial substrate according to claim 17, wherein the [000-1] C direction is selected as said <0001> direction in the step of obtaining said substrate.

20. A silicon carbide single crystal epitaxial substrate, being produced by a method according to any one of claims 17 to 19, and a diameter thereof is 20 mm or more.

## Patentansprüche

1. Aus einem Siliciumcarbid-Einkristall bestehender Impfkristall mit:
einer Einkristall-Wachstumsfläche, die in einem Winkel im Bereich von mindestens 3 Grad bis höchstens 60 Grad im Hinblick auf die (11-20)-Fläche zu einer Richtung geneigt ist, die in einem Winkel im Bereich von mindestens -45 Grad bis höchstens 45 Grad aus einer <0001>-Richtung zur [1-100]-Richtung geneigt ist.

2. Impfkristall nach Anspruch 1, wobei die <0001>-Richtung die [0001]-Si-Richtung ist.

3. Impfkristall nach Anspruch 1, wobei die <0001>-Richtung die [000-1]-C-Richtung ist.

4. Impfkristall nach einem der Ansprüche 1 bis 3, wobei die Einkristall-Wachstumsfläche in einem Winkel im Bereich von mindestens 3 Grad bis höchstens 30 Grad im Hinblick auf die (11-20)-Fläche geneigt ist.

5. Impfkristall nach einem der Ansprüche 1 bis 3, wobei die Einkristall-Wachstumsfläche in einem Winkel im Bereich von mindestens 6 Grad bis höchstens 30 Grad im Hinblick auf die (11-20)-Fläche geneigt ist.

6. Aus einem Siliciumcarbid-Einkristall bestehendes Einkristallsubstrat mit:
einer epitaxialen Wachstumsfläche, die in einem Winkel im Bereich von mindestens 3 Grad bis höchstens 60 Grad im Hinblick auf die (11-20)-Fläche zu einer Richtung geneigt ist, die in einem Winkel im Bereich von mindestens -45 Grad bis höchstens 45 Grad aus einer <0001>-Richtung zur [1-100]-Richtung geneigt ist.

7. Einkristallsubstrat nach Anspruch 6, wobei die <0001>-Richtung die [0001]-Si-Richtung ist.

8. Einkristallsubstrat nach Anspruch 6, wobei die <0001>-Richtung die [000-1]-C-Richtung ist.

9. Einkristallsubstrat nach einem der Ansprüche 6 bis 8, wobei die epitaxiale Wachstumsfläche in einem Winkel im Bereich von mindestens 3 Grad bis höchstens 30 Grad im Hinblick auf die (11-20)-Fläche geneigt ist.

10. Einkristallsubstrat nach einem der Ansprüche 6 bis 8, wobei die epitaxiale Wachstumsfläche in einem Winkel im Bereich von mindestens 6 Grad bis höchstens 30 Grad im Hinblick auf die (11-20)-Fläche geneigt ist.

11. Verfahren zur Herstellung eines Siliciumcarbid-Einkristallblocks mit den Schritten:
Erhalten eines Impfkristalls, der aus einem Siliciumcarbid-Einkristall besteht und eine Einkristall-Wachstumsfläche hat, die in einem Winkel im Bereich von mindestens 3 Grad bis höchstens 60 Grad im Hinblick auf die (11-20)-Fläche zu einer Richtung geneigt ist, die in einem Winkel im Bereich von mindestens -45 Grad bis höchstens 45 Grad aus einer <0001>-Richtung zur [1-100]-Richtung geneigt ist; und
Aufwachsenlassen eines Siliciumcarbid-Einkristalls durch ein Sublimationsrekristallisationsverfahren auf der Einkristall-Wachstumsfläche des Impfkristalls.

12. Verfahren zur Herstellung eines Siliciumcarbid-Einkristallblocks nach Anspruch 11, wobei die [0001]-Si-Richtung als die <0001>-Richtung im Schritt des Erhaltens des Impfkristalls ausgewählt wird.

13. Verfahren zur Herstellung des Siliciumcarbid-Einkristallblocks nach Anspruch 11, wobei die [000-1]-C-Richtung als die <0001>-Richtung im Schritt des Erhaltens des Impfkristalls ausgewählt wird.

14. Siliciumcarbid-Einkristallblock, der durch ein Verfahren nach einem der Ansprüche 11 bis 13 hergestellt ist und bei dem ein Durchmesser mindestens 20 mm beträgt.

15. Siliciumcarbid-Einkristallwafer, der durch Bearbeiten und Polieren des Siliciumcarbid-Einkristallblocks nach Anspruch 14 hergestellt ist und bei dem ein Durchmesser mindestens 20 mm beträgt.

16. Epitaxiales Siliciumcarbid-Einkristallsubstrat mit:
dem Siliciumcarbid-Einkristallwafer nach Anspruch 15; und
einem epitaxialen Siliciumcarbid-Einkristallfilm, der auf dem Siliciumcarbid-Einkristallwafer aufgewachsen ist.

17. Verfahren zur Herstellung eines epitaxialen Siliciumcarbid-Einkristallsubstrats mit den Schritten:
Erhalten eines Substrats, das aus einem Siliciumcarbid-Einkristall besteht und eine Einkristall-Wachstumsfläche hat, die in einem Winkel im Bereich von mindestens 3 Grad bis höchstens 60 Grad im Hinblick auf die (11-20)-Fläche zu einer Richtung geneigt ist, die in einem Winkel im Bereich von mindestens -45 Grad bis höchstens 45 Grad aus einer <0001>-Richtung zur [1-100]-Richtung geneigt ist; und
Aufwachsenlassen eines epitaxialen Siliciumcarbid-Einkristallfilms auf der Einkristall-Wachstumsfläche des Substrats.

18. Verfahren zur Herstellung des epitaxialen Siliciumcarbid-Einkristallsubstrats nach Anspruch 17, wobei die [0001]-Si-Richtung als die <0001>-Richtung im Schritt des Erhaltens des Substrats ausgewählt wird.

19. Verfahren zur Herstellung des epitaxialen Siliciumcarbid-Einkristallsubstrats nach Anspruch 17, wobei die [000-1]-C-Richtung als die <0001>-Richtung im Schritt des Erhaltens des Substrats ausgewählt wird.

20. Epitaxiales Siliciumcarbid-Einkristallsubstrat, das durch ein Verfahren nach einem der Ansprüche 17 bis 19 hergestellt ist und bei dem ein Durchmesser mindestens 20 mm beträgt.

## Revendications

1. Cristal germe constitué d'un monocristal de carbure de silicium comprenant :
une face de croissance de monocristal inclinée sous un angle compris entre 3 degrés ou plus et 60 degrés ou moins par rapport à la face (11-20) vers une direction inclinée sous un angle compris entre -45 degrés ou plus et 45 degrés ou moins à partir d'une direction <0001> vers la direction [1-100].

2. Cristal germe selon la revendication 1, dans lequel ladite direction <0001> est la direction [0001] Si.

3. Cristal germe selon la revendication 1, dans lequel ladite direction <0001> est la direction [000-1] C.

4. Cristal germe selon l'une quelconque des revendications 1 à 3, dans lequel ladite face de croissance de monocristal est inclinée sous un angle compris entre 3 degrés ou plus et 30 degrés ou moins par rapport à ladite face (11-20).

5. Cristal germe selon l'une quelconque des revendications 1 à 3, dans lequel ladite face de croissance de monocristal est inclinée sous un angle compris entre 6 degrés ou plus et 30 degrés ou moins par rapport à ladite face (11-20).

6. Substrat de monocristal constitué d'un monocristal de carbure de silicium comprenant :
une face de croissance épitaxiale inclinée sous un angle compris entre 3 degrés ou plus et 60 degrés ou moins par rapport à la face (11-20) vers une direction inclinée sous un angle compris entre -45 degrés ou plus et 45 degrés ou moins à partir d'une direction <0001> vers la direction [1-100].

7. Substrat de monocristal selon la revendication 6, dans lequel ladite direction <0001> est la direction [0001] Si.

8. Substrat de monocristal selon la revendication 6, dans lequel ladite direction <0001> est la direction [000-1] C.

9. Substrat de monocristal selon l'une quelconque des revendications 6 à 8, dans lequel ladite face de croissance épitaxiale est inclinée sous un angle compris entre 3 degrés ou plus et 30 degrés ou moins par rapport à ladite face (11-20).

10. Substrat de monocristal selon l'une quelconque des revendications 6 à 8, dans lequel ladite face de croissance épitaxiale est inclinée sous un angle compris entre 6 degrés ou plus et 30 degrés ou moins par rapport à ladite face (11-20).

11. Procédé de production d'un lingot de monocristal de carbure de silicium comprenant les étapes consistant :
à obtenir un cristal germe constitué d'un monocristal de carbure de silicium et présentant une face de croissance de monocristal inclinée sous un angle compris entre 3 degrés ou plus et 60 degrés ou moins par rapport à la face (11-20) vers une direction inclinée sous un angle compris entre -45 degrés ou plus et 45 degrés ou moins à partir d'une direction <0001> vers la direction [1-100] ; et
à laisser croître un monocristal de carbure de silicium par un procédé de recristallisation par sublimation sur ladite face de croissance de monocristal dudit cristal germe.

12. Procédé de production d'un lingot de monocristal de carbure de silicium selon la revendication 11, dans lequel la direction [0001] Si est choisie comme ladite direction <0001> dans l'étape consistant à obtenir ledit cristal germe.

13. Procédé de production du lingot de monocristal de carbure de silicium selon la revendication 11, dans lequel la direction [000-1] C est choisie comme ladite direction <0001> dans l'étape consistant à obtenir ledit cristal germe.

14. Lingot de monocristal de carbure de silicium produit par un procédé selon l'une quelconque des revendications 11 à 13 et un diamètre de celui-ci est de 20 mm ou supérieur.

15. Pastille de monocristal de carbure de silicium produite par traitement et polissage du lingot de monocristal de carbure de silicium selon la revendication 14, et un diamètre de celle-ci est de 20 mm ou supérieure.

16. Substrat épitaxial de monocristal de carbure de silicium comprenant :
la pastille de monocristal de carbure de silicium selon la revendication 15 ; et
un film épitaxial de monocristal de carbure de silicium ayant cru sur ladite pastille de monocristal de carbure de silicium.

17. Procédé de production d'un substrat épitaxial de monocristal de carbure de silicium comprenant les étapes consistant :
à obtenir un substrat constitué d'un monocristal de carbure de silicium et présentant une face de croissance de monocristal inclinée sous un angle compris entre 3 degrés ou plus et 60 degrés ou moins par rapport à la face (11-20) vers une direction inclinée sous un angle compris entre -45 degrés ou plus et 45 degrés ou moins à partir d'une direction <0001> vers la direction [1-100] ; et
à laisser croître un film épitaxial de monocristal de carbure de silicium sur ladite face de croissance de monocristal dudit substrat.

18. Procédé de production du substrat épitaxial de monocristal de carbure de silicium selon la revendication 17, dans lequel la direction [0001] Si est choisie comme ladite direction <0001> dans l'étape consistant à obtenir ledit substrat.

19. Procédé de production du substrat épitaxial de monocristal de carbure de silicium selon la revendication 17, dans lequel la direction [000-1] C est choisie comme ladite direction <0001> dans l'étape consistant à obtenir ledit substrat.

20. Substrat épitaxial de monocristal de carbure de silicium produit par le procédé selon l'une quelconque des revendications 17 à 19 et un diamètre de celui-ci est de 20 mm ou supérieur.
